(19) Europäisches Patentamt
European Patent Office
Office européen des brevets

(11) **EP 4 276 537 A1**

(12) **EUROPEAN PATENT APPLICATION**

(43) Date of publication:
**15.11.2023 Bulletin 2023/46**

(21) Application number: **22172390.1**

(22) Date of filing: **09.05.2022**

(51) International Patent Classification (IPC):
*G03F 7/20* (2006.01)     *G01N 21/88* (2006.01)
*G01N 21/95* (2006.01)     *G01N 21/956* (2006.01)
*G02F 1/01* (2006.01)     *G06T 7/00* (2017.01)

(52) Cooperative Patent Classification (CPC):
**G03F 7/70616; G01N 21/88; G01N 21/8806;**
**G01N 21/9501; G01N 21/956; G03F 7/705;**
**G03F 7/70566; G03F 7/70625; G03F 7/70633;**
**G03F 7/7065; G06T 7/0004;** G01N 2021/8809;
G01N 2021/8822; G01N 2021/8835;
G01N 2021/8848

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **FAGGINGER AUER, Bastiaan, Onne**
**5500AH Veldhoven (NL)**

• **DE ZWART, Siebe, Tjerk**
**5500AH Veldhoven (NL)**
• **NGAI, Anthony, Kwok, Yu**
**5500 AH Veldhoven (NL)**
• **LIU, Xuewen**
**5500AH Veldhoven (NL)**
• **AKKERMANS, Johannes, Antonius, Gerardus**
**5500 AH Veldhoven (NL)**

(74) Representative: **ASML Netherlands B.V.**
**Corporate Intellectual Property**
**P.O. Box 324**
**5500 AH Veldhoven (NL)**

(54) **ILLUMINATION MODE SELECTOR AND ASSOCIATED OPTICAL METROLOGY TOOL**

(57)     Disclosed is an illumination mode selector for use in an illumination branch of an optical metrology tool, and an associated optical metrology tool. The illumination mode selector comprises a plurality of illumination apertures; and at least one polarization-changing optical element. Each of the illumination apertures and each of the at least one polarization-changing optical element are individually switchable into an illumination path of the optical metrology tool.

Fig. 10

**Description**

TECHNICAL FIELD

The present invention relates to methods of metrology performed to maintain performance in the manufacture of devices by patterning processes such as lithography. The invention further relates to methods of manufacturing devices using lithographic techniques. The invention yet further relates to computer program products for use in implementing such methods. In particular, the invention relates to an illumination mode selector for a metrology tool.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance.

To overcome these difficulties, sophisticated fine-tuning steps may be applied to the lithographic projection apparatus and/or design layout. These include, for example, but are not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Such control loops and/or lithographic apparatus monitoring relies on accurate metrology. Various metrology operations may be used to measure features of a design. If measured on different metrology systems (more specifically, different physical instances or metrology units of a single metrology system type or model), the data from a metrology operation on one system may not match the data from the same metrology operation on a different system. A matching method has been described which provides a generic framework to improve matching between systems by exhaustive use of available system calibration data. However, some present metrology tools do not have sufficient measurement configurations to properly utilize this matching method. It would be desirable to provide more measurement configurations in such metrology tools.

SUMMARY

According to a first aspect of the invention, there is provided an illumination mode selector for use in an illumination branch of an optical metrology tool, the illumination mode selector comprising: a plurality of illumination apertures; and at least one polarization-changing optical element; wherein each of the illumination apertures and each of the at least one polarization-changing optical element are individually switchable into an illumination path of the optical metrology tool.

According to a second aspect of the invention, there is provided an optical metrology tool comprising: an illumination branch for directing illumination onto a sample, said illumination branch comprising an illumination polarizing beam splitter having a horizontal polarization axis; a detection branch for detecting said illumination having been reflected and/or scattered by said sample; and one or both of: an illumination mode selector in the illumination branch and a detection mode selector in the detection mode branch; wherein said illumination mode selector comprises: a plurality of illumination apertures; and at least one polarization-changing optical element; wherein each of the illumination apertures and each of the at least one polarization-changing optical element are individually switchable into an illumination path of the optical metrology tool; and wherein said detection mode selector comprises: at least one detection aperture; and at least one detection polarization-changing optical element; wherein each at least one detection aperture and each of the at least one polarization-changing optical element are individually switchable into said detection branch, said detection branch comprising a detection polarizing beam splitter having a horizontal polarization axis.

According to a third aspect of the invention, there is provided a method of determining a mapped intensity metric, the method comprising: configuring the optical metrology tool of the second aspect in a plurality of different measurement configurations, said plurality of different measurement configurations comprising one or more measurement configurations obtained by a respective switching of each of the at least one polarization-changing optical elements into the illumination path of the optical metrology tool of the second aspect; building a virtual system matrix from a plurality of observables, each observable corresponding to a respective measurement configuration of said plurality of measurement configurations, said plurality of observables numbering at least 9.

BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:

Figure 1 depicts a schematic overview of a lithographic apparatus, according to an embodiment.
Figure 2 depicts a schematic overview of a lithographic cell, according to an embodiment.
Figure 3 depicts a schematic representation of holistic lithography, representing a cooperation between three technologies to optimize semiconductor manufacturing, according to an embodiment.
Figure 4 is a schematic illustration of a scatterometry apparatus;
Figure 5 comprises (a) a schematic diagram of a dark field scatterometer for use in measuring targets according to embodiments of the invention using a first pair of illumination apertures, (b) a detail of diffraction spectrum of a target grating for a given direction of illumination;
Figure 6 illustrates a summary of operations of a method for determining a mapped intensity metric, according to an embodiment.
Figure 7 illustrates mapping intensity metrics from two manufacturing systems to a reference system such that the intensity metrics from the manufacturing systems can be compared, according to an embodiment.
Figure 8 illustrates mapping (e.g., determining a mapped intensity metric) based on a transformation matrix, according to an embodiment.
Figure 9 illustrates mapping individual intensities directly from different points on a pupil, and mapping corresponding intensities from reciprocal points on the pupil, according to an embodiment.
Figure 10 is a schematic illustration of an illumination mode selector according to an embodiment.

DETAILED DESCRIPTION

Various metrology operations may be used to measure features of a design. If measured on different metrology systems, the data from a metrology operation on one system may not match the data from the same metrology operation on a different system. For example, in the context of integrated circuits, matching between measured overlay values measured on different overlay measurement systems is often out of specification. A current approach for ensuring that data from different metrology systems is comparable uses the Jones Framework. The Jones-framework is a ray-based framework, which accounts for the polarization state of the light used by the system for measuring (e.g., a light / pupil based metrology system). However, this current approach ignores any phase-shift of the light as it travels through the metrology system and thus it fails to capture phase related differences between systems. However, phase effects are a major source of system-to-system matching issues. For example, the objective retardation (a.k.a. alpha-map) and the phase-induced channel leakage for a given system are thought to be causes of the system-to-system matching issues.

Advantageously, the present method(s) and system(s) are configured to provide a generic framework to improve matching between systems by exhaustive use of available system calibration data. These calibration data are assumed to be present in the form of the incoming and outgoing density matrices (e.g., $\rho_{in}$ and $M_{out}$). In the present method(s) and system(s), an intensity metric (e.g., which may, in some embodiments, be and/or include an intensity image (associated with a pupil), an intensity map, a set of intensity values, and/or other intensity metrics) is determined for a manufacturing system (e.g., a light/pupil based system configured to measure overlay continuing with the example above). The intensity metric is determined based on a reflectivity of a location on a substrate (e.g., a wafer and/or other substrates), a manufacturing system characteristic, and/or other information. A mapped intensity metric for a reference system is determined. The reference system has a reference system characteristic. The mapped intensity metric is determined based on the intensity metric, the manufacturing system characteristic, and the reference system characteristic, to mimic the determination of the intensity metric for the manufacturing system using the reference system. In this way, any number of intensity metrics from any number of manufacturing systems may be mapped to this reference system to facilitate comparison of data from different manufacturing systems.

Although specific reference may be made in this text to the manufacture of ICs, and/or metrology related to the manufacture of IC's, the description herein has many other possible applications. For example, it may be employed in the manufacture of integrated optical systems, guidance and detection patterns for magnetic domain memories, liquid-crystal display panels, thin-film magnetic heads, etc. In these alternative applications, the skilled artisan will appreciate that, in the context of such alternative applications, any use of the terms "reticle", "wafer" or "die" in this text should be considered as interchangeable with the more general terms "mask", "substrate" and "target portion", respectively. In addition, it should be noted that the method described herein may have many other possible applications in diverse fields such as language processing systems, self-driving cars, medical imaging and diagnosis, semantic segmentation, denoising, chip design, electronic design automation, etc. The present method may be applied in any fields where quantifying uncertainty in machine learning model predictions is advantageous.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

A patterning device may comprise, or may form, one or more design layouts. The design layout may be generated utilizing CAD (computer-aided design) programs. This process is often referred to as EDA (electronic design automation). Most CAD programs follow a set of predetermined design rules in order to create functional design layouts/patterning devices. These rules are set based processing and design limitations. For example, design rules define the space tolerance between devices (such as gates, capacitors, etc.) or interconnect lines, to ensure that the devices or lines do not interact with one another in an undesirable way. One or more of the design rule limitations may be referred to as a "critical dimension" (CD). A critical dimension of a device can be defined as the smallest width of a line or hole, or the smallest space between two lines or two holes. Thus, the CD regulates the overall size and density of the designed device. One of the goals in device fabrication is to faithfully reproduce the original design intent on the substrate (via the patterning device).

The term "reticle," "mask," or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective; binary, phase-shifting, hybrid, etc.), examples of other such patterning devices include a programmable mirror array.

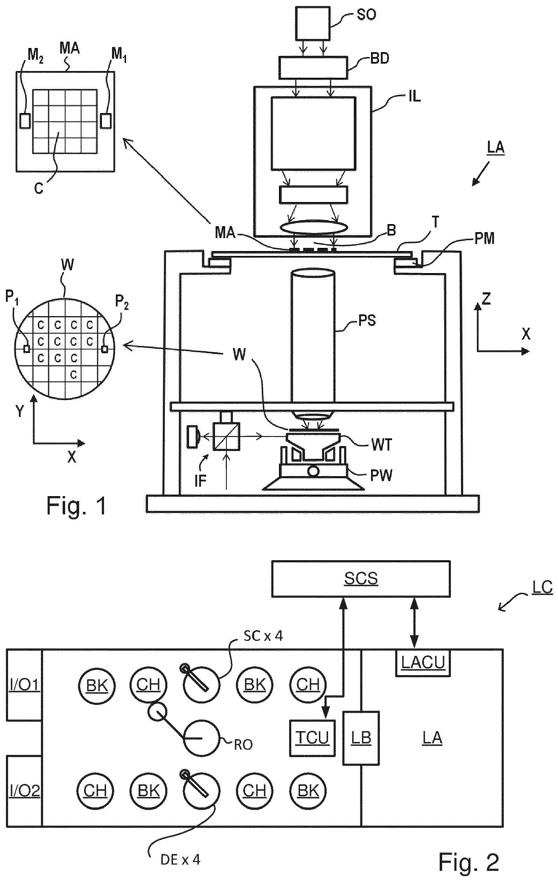

As a brief introduction, Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT configured to hold a substrate (e.g., a resist coated wafer) W and coupled to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

Figure 2 depicts a schematic overview of a lithographic cell LC. As shown in Figure 2 the lithographic apparatus LA may form part of lithographic cell LC, also sometimes referred to as a lithocell or (litho)cluster, which often also includes apparatus to perform pre- and post-exposure processes on a substrate W. Conventionally, these include spin coaters SC configured to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W (Figure 1) exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W (Figure 1), and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

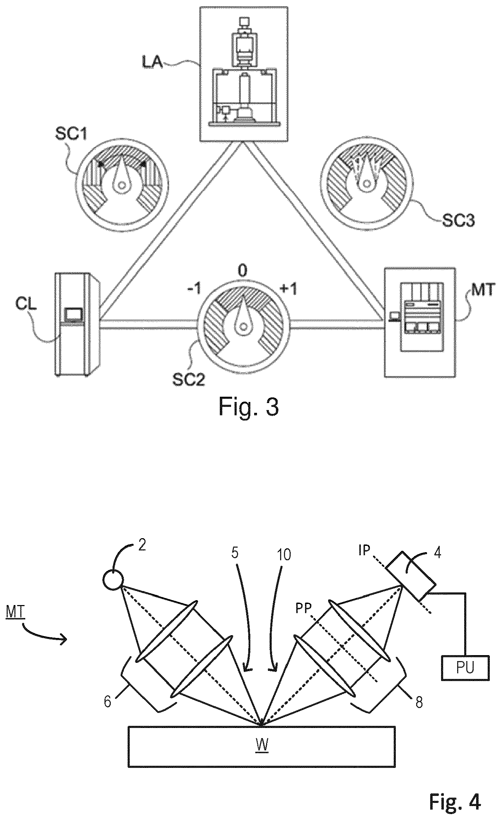

Figure 3 depicts a schematic representation of holistic lithography, representing a cooperation between three technologies to optimize semiconductor manufacturing. Typically, the patterning process in a lithographic apparatus LA is one of the most critical steps in the processing which requires high accuracy of dimensioning and placement of structures on the substrate W (Figure 1). To ensure this high accuracy, three systems (in this example) may be combined in a so called "holistic" control environment as schematically depicted in Figure. 3. One of these systems is the lithographic apparatus LA which is (virtually) connected to a metrology apparatus (e.g., a metrology tool) MT (a second system), and to a computer system CL (a third system). A "holistic" environment may be configured to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology apparatus (tool) MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequent measurements of the structures created, e.g., for process control and verification. Tools to make such measurements include metrology tool (apparatus) MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure features of a substrate such as gratings using light from soft x-ray and visible to near-IR wavelength range, for example.

In some embodiments, a scatterometer MT is an angular resolved scatterometer. In these embodiments, scatterometer reconstruction methods may be applied to the measured signal to reconstruct or calculate properties of a grating and/or other features in a substrate. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In some embodiments, scatterometer MT is a spectroscopic scatterometer MT. In these embodiments, spectroscopic scatterometer MT may be configured such that the radiation emitted by a radiation source is directed onto target features of a substrate and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In some embodiments, scatterometer MT is a ellipsometric scatterometer. The ellipsometric scatterometer allows for determining parameters of a lithographic process by measuring scattered radiation for each polarization states. Such a metrology apparatus (MT) emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In some embodiments, scatterometer MT is adapted to measure the overlay of two misaligned gratings or periodic structures (and/or other target features of a substrate) by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in patent application EP1,628,164A, such that any asymmetry is clearly distinguishable. This provides a way to measure misalignment in gratings. Further examples for measuring overlay may be found in PCT patent application publication no. WO 2011/012624 or US patent application US 20160161863, incorporated herein by reference in their entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure (e.g., feature in a substrate) may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings and/or other features in a substrate, formed by a lithographic process, commonly in resist, but also after etch processes, for example. Typically the pitch and line-width of the structures in the gratings depend on the measurement optics (in particular the NA of the optics) to be able to capture diffraction orders coming from the metrology targets. A diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

A metrology apparatus, such as a scatterometer MT, is depicted in Figure 4. It comprises a radiation source 2 (e.g., a broadband (white light) radiation source) which projects radiation 5 onto a substrate W via projection optical system 6. The reflected or scattered radiation 8 is collected by an objective lens system 8 and passed to a detector 4. The scattered radiation 8 as detected by detector 4 can then be processed by processing unit PU. Also shown is a pupil plane PP and image plane IP of the objective lens system 8. The terms "pupil plane" and "field plane" within this specification may refer to respectively these planes or any planes conjugate thereto. Such a scatterometer may be configured as a normal-incidence scatterometer or (as shown) an oblique-incidence scatterometer. In some embodiments, the projection optical system 6 and objective lens system 8 are combined; i.e., the same objective lens system is used to both illuminate the substrate and collect the scattered radiation therefrom.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

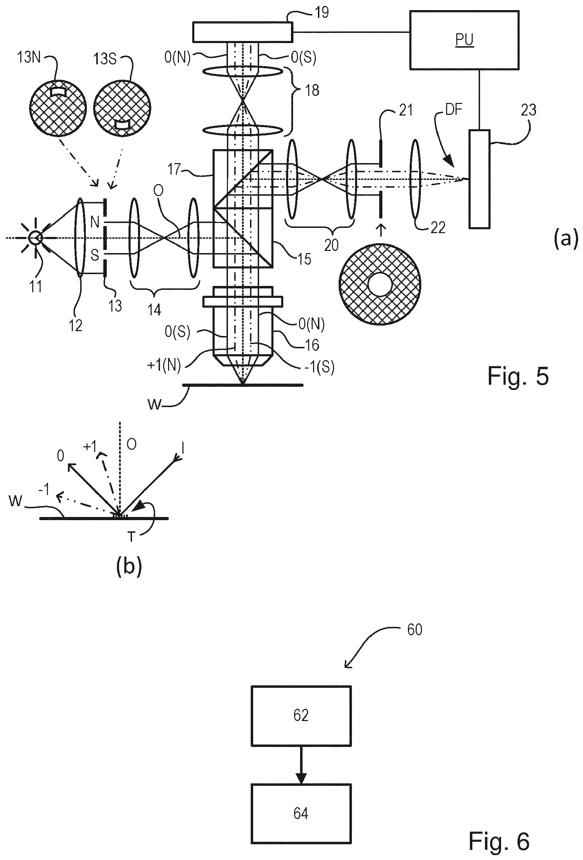

Figure 5(a) presents an embodiment of a metrology apparatus and, more specifically, a dark field scatterometer adaptable for method described herein. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. This may be achieved by using an illumination mode selector as described. In the example illustrated, aperture plate 13 is configured for dark-field metrology, having different forms labeled 13N and 13S. For the methods disclosed herein, however, a bright-field metrology technique (e.g., known as in-device metrology IDM) may be used with detection in the pupil branch of the apparatus. Such a technique may use a full open aperture, for example. In the present metrology techniques, the tool may further be configured for polarized illumination and detection.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram. At least the 0 and +1 orders diffracted by the target T on substrate W are collected by objective lens 16 and directed back through beam splitter 15.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. It is this pupil plane image which is primarily used for the measurement techniques described herein (e.g., in-device metrology IDM).

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present. This branch is typically used for dark-field metrology methods.

It is often desirable to be able computationally determine how a patterning process would produce a desired pattern on a substrate. Computational determination may comprise simulation and/or modeling, for example. Models and/or simulations may be provided for one or more parts of the manufacturing process. For example, it is desirable to be able to simulate the lithography process of transferring the patterning device pattern onto a resist layer of a substrate as well as the yielded pattern in that resist layer after development of the resist, simulate metrology operations such as the determination of overlay, and/or perform other simulations. The objective of a simulation may be to accurately predict, for example, metrology metrics (e.g., overlay, a critical dimension, a reconstruction of a three dimensional profile of features of a substrate, a dose or focus of a lithography apparatus at a moment when the features of the substrate were printed with the lithography apparatus, etc.), manufacturing process parameters (e.g., edge placements, aerial image intensity slopes, sub resolution assist features (SRAF), etc.), and/or other information which can then be used to determine whether an intended or target design has been achieved. The intended design is generally defined as a pre-optical proximity correction design layout which can be provided in a standardized digital file format such as GDSII, OASIS or another file format.

Simulation and/or modeling can be used to determine one or more metrology metrics (e.g., performing overlay and/or other metrology measurements), configure one or more features of the patterning device pattern (e.g., performing optical proximity correction), configure one or more features of the illumination (e.g., changing one or more characteristics of a spatial / angular intensity distribution of the illumination, such as change a shape), configure one or more features of the projection optics (e.g., numerical aperture, etc.), and/or for other purposes. Such determination and/or configuration can be generally referred to as mask optimization, source optimization, and/or projection optimization, for example. Such optimizations can be performed on their own, or combined in different combinations. One such example is source-mask optimization (SMO), which involves the configuring of one or more features of the patterning device pattern together with one or more features of the illumination. The optimizations may use the parameterized model described herein to predict values of various parameters (including images, etc.), for example.

In some embodiments, an optimization process of a system may be represented as a cost function. The optimization process may comprise finding a set of parameters (design variables, process variables, etc.) of the system that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function can also be the maximum of these deviations (i.e., worst deviation). The term "evaluation points" should be interpreted broadly to include any characteristics of the system or fabrication method. The design and/or process variables of the system can be confined to finite ranges and/or be interdependent due to practicalities of implementations of the system and/or method. In the case of a lithographic projection apparatus, the constraints are often associated with physical properties and characteristics of the hardware such as tunable ranges, and/or patterning device manufacturability design rules. The evaluation points can include physical points on a resist image on a substrate, as well as non-physical characteristics such as dose and focus, for example.

To ensure that the measured parameter of interest (e.g., overlay values) from different metrology tools match, a normalization of the measurement signals of each tool may be performed using that tool's calibration data. By matching these measurement signals through normalization, the parameter of interest values between different tools are also matched. Current signal normalization techniques include a diffraction efficiencies (DE) approach, where the measurement signal is normalized via a simulated signal of a perfect mirror, or an observable mapping (OM) approach where measured intensities are mapped to a fixed reference system by combining different channels and multiple wafer rotations. (EP3961304). Observable mapping has been described in European patent application EP3961304, which is incorporated herein in its entirety. OM tries to reconstruct or "build" the physical response of a fixed reference system as a linear combination of a set of physical responses of the actual measurement system. The same linear combination is applied to the measured intensities to obtain the "mapped" intensity on the reference system. This approach will now described in more detail in combination with Figures 6 to 9.

Figure 6 is a flow diagram illustrating a summary of operations of a method 60 for determining a mapped intensity metric that can be used for comparison to similar metrics among manufacturing systems (e.g., manufacturing systems such as those shown in Figures 1 to 5). This method is described in more detail in European patent application EP3961304, which is incorporated herein in its entirety. At an operation 62, an intensity metric for a manufacturing system is determined. At an operation 64, a mapped intensity metric for a reference system is determined. The operations of method 60 presented below are intended to be illustrative; the method 60 may be accomplished with one or more additional operations not described, and/or without one or more of the operations discussed. Additionally, the order in which the operations of method 60 are illustrated in Figure 6 and described below is not intended to be limiting. One or more portions of method 60 may be implemented (e.g., by simulation, modeling, etc.) in one or more processing devices (e.g., one or more processors). The one or more processing devices may include one or more devices executing some or all of the operations of method 60 in response to instructions stored electronically on an electronic storage medium. The one or more processing devices may include one or more devices configured through hardware, firmware, and/or software to be specifically designed for execution of one or more of the operations of method 60, for example.

Method 60 is configured to provide a generic framework to improve matching between systems using available system calibration data. These calibration data are assumed to be present in the form of the incoming and outgoing density matrices (e.g., $\rho_{in}$ and $M_{out}$) and/or in other forms. The density matrices are related to the Jones matrices of the incoming (from source to target) and outgoing (from target to detector) optical paths of a manufacturing (e.g., metrology) system. A Jones matrix associated with an optical path describes how the optical electric fields propagates along said path. The associated density matrix is defined as the product of the associated Jones matrix with the conjugate transpose (a.k.a. Hermitian transpose, both designated by "†") of that same Jones matrix. More specifically, $\rho_{in} = J_{in}J_{in}^{\dagger}$, and $M_{out} = J_{out}^{\dagger}J_{out}$, with $J_{in}, J_{out}$ the respective Jones matrices.

In method 60, an intensity metric (e.g., which may, in some embodiments, be and/or include an intensity image (e.g., associated with a pupil, e.g., an angularly resolved image obtained at a pupil plane of the metrology system or conjugate thereof), an intensity map, a set of intensity values, and/or other intensity metrics) is determined for a manufacturing system (e.g., a light/pupil based system). The intensity metric is determined based on a reflectivity of a location on a substrate (e.g., a wafer and/or other substrates), a manufacturing system characteristic, and/or other information. A corresponding mapped intensity metric for a reference system is determined. The reference system has a reference system characteristic. The manufacturing system characteristic and/or the reference system characteristic may be and/or include one or more matrices comprising calibration data and/or other information for a given system (e.g., as further described below). The mapped intensity metric may be determined based on the intensity metric, the manufacturing system characteristic, the reference system characteristic, and/or other information, to mimic the determination of the intensity metric for the manufacturing system using the reference system. In this way, any number of intensity metrics from any number of manufacturing systems may be mapped to this reference system to facilitate comparison of data from different manufacturing systems.

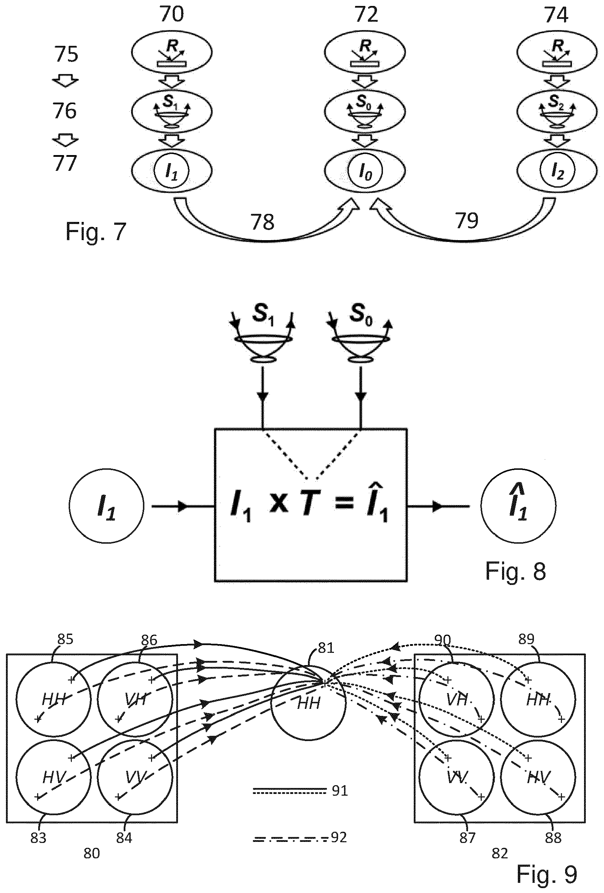

Figure 7 illustrates these principles with three schematic systems 70, 72, and 74. Figure 7 illustrates mapping 78, 79 intensity metrics 77 from two manufacturing systems 70 and 74 to a reference system 72 such that the intensity metrics 77 from the manufacturing systems 70, 74 can be compared. Systems 70 and 74 may be and/or include metrology and/or other manufacturing systems. Such systems may be configured to measure overlay, as just one example, and/or other metrics. Such systems may comprise scatterometer machines such as illustrated in Figure 4 or 5, for example. System 70 is indicated by the subscript "1". System 72 may be a reference system indicated by the subscript "0", and system 74 may be indicated by the subscript "2". The systems 70, 72, and 74 are illustrated as measuring 75 a substrate with a certain (complex valued) reflectivity R. One or more system characteristics 76 are illustrated as being embedded in a system matrix S. The resulting measured pupil intensity 77 (e.g., an intensity metric) is represented by I. As shown in Figure 7, $I_1$ and $I_2$ may be mapped 78, 79 to the reference system 72 to facilitate comparison. The substrate reflectivity itself is not retrieved or reconstructed, but instead the intensity that would have been observed had the intensity metric $I_1$ or $I_2$ been measured on reference system 72 is determined. As shown in Figure 7, intensity metrics from systems 70 and 74 are mapped to reference system 72, and can be compared on that level.

In some embodiments (as described herein), reference system 72 is an idealized system with predetermined characteristics. The predetermined characteristics may include system operating parameters and/or set points, calibration settings and/or other data, and/or other information. In some embodiments, the predetermined characteristics may be measured for a given manufacturing system, electronically obtained from a manufacturing system and/or electronic storage associated with such a system, programmed by a user (e.g., for a virtual system), assigned by a user, and/or may include other information. In some embodiments, the reference system may be a physical system or a virtual system. In some embodiments, the reference system may represent an average or typical system. In some embodiments, the reference system is configured to represent a plurality of different (physical and/or virtual) manufacturing systems. In some embodiments, the reference system is virtual, and the manufacturing system(s) is (are) physical.

Returning to Figure 6 and method 60, at an operation 62, an intensity metric for a manufacturing system is determined (e.g., 77 for systems 70 or 74 shown in Figure 7). The intensity metric (e.g., 77) is determined based on a reflectivity (e.g., 75 shown in Figure 7) of a location on a substrate (and/or reflectivities of several locations on the substrate), a manufacturing system characteristic (e.g., 76 shown in Figure 7), and/or other information. In some embodiments, the manufacturing system characteristic is one or more matrices and/or other arrangements of characteristics that comprise calibration data and/or other data for the manufacturing system. The manufacturing system matrix (or matrices) may include any data that may be uniquely associated with a particular manufacturing system so that any variation caused by a manufacturing system itself is represented in, and/or otherwise accounted for by, the manufacturing system matrix (or matrices).

Method 60 combines different "measurement channels", each channel characterized by an incoming-outgoing-polarization and grating-to-sensor-angle (and wavelength), and/or other information. Each channel corresponds to a different set of density matrices (and system matrices) and also to different measured Intensities I. A channel is an aggregate of measured data, calibration data, and labels. It includes a set of points, each point having a position in the pupil-plane, a measured intensity value (all together forming a pupil intensity image), an incoming density matrix, and an outgoing density matrix. Said channel also has labels: the associated incoming polarization value, outgoing polarization value, the wavelength, and a grating-to-sensor angle. Additional aspects of operation 62 are further described below in context with operation 64.

At an operation 64, a mapped intensity metric (e.g., 78 and/or 79 in Figure 7) for a reference system (e.g., 72 in Figure 7) is determined. The mapped intensity metric comprises an intensity metric that would have been observed on the reference system given the reflectivity of the location on the substrate. The mapped intensity metric is determined to mimic the determination of the intensity metric for a manufacturing system, but using the reference system. This may facilitate a comparison of data from different manufacturing systems.

By way of a non-limiting example, the intensity metric may be associated with overlay measured as part of a semiconductor manufacturing process, and the mapped intensity metric may be associated with a mapped overlay, such that the mapped overlay can be compared to other mapped overlays from other manufacturing systems also associated with the semiconductor manufacturing process. In some embodiments, the intensity metric is an intensity in an intensity-image (pupil), an intensity image itself, an intensity map, a set of intensity values, and/or other intensity metrics. A mapped overlay (for comparison with other overlay values measured by other manufacturing systems) may be determined by taking all these intensities together (in a linear or non-linear way) with certain weight-factors (e.g., as described below). Overlay is not necessarily associated with a single point in a pupil.

Such a method may make use of the Jones Framework. The Jones framework describes the propagation of polarized light through an optical system in terms of Jones matrices. A Jones matrix of an optical element, $J$, is a 2x2 complex matrix that acts on a $2 \times 1$ electric field input-vector $E_{in}$ to produce a 2x1 electric field output-vector $E_{out}$, according to $E_{out} = JE_{in}$. Each electric field $E$ is expressed as a linear combination of two chosen orthogonal unit-(field-) vectors that span a 2D subspace perpendicular to the propagation direction of the light. Said unit vectors constitute the local polarization directions of the light. The Jones matrix of an optical system is the matrix product of the Jones matrices of the associated optical elements.

The reference system may have a reference system characteristic and/or other associated information. In some embodiments, the reference system characteristic is a matrix (or a plurality of matrices) that comprises calibration data for the reference system and/or other information. In some embodiments, the reference system characteristic is one or more matrices and/or other arrangements of characteristics that comprise calibration data and/or other data for the manufacturing system. The reference system matrix (or matrices) may include any data that may be uniquely associated with the reference system so that any variation caused by a reference system itself is represented in, and/or otherwise accounted for by, the reference system matrix (or matrices).

The mapped intensity metric may be determined based on the intensity metric, the manufacturing system characteristic, the reference system characteristic, and/or other information. In some embodiments, the manufacturing system matrix and the reference system matrix form a transform matrix. The components of the transform matrix "T" are determined by the system matrices of the manufacturing system(s) and the matrices of the reference system.

Figure 8 illustrates mapping (e.g., determining a mapped intensity metric) based on a transformation matrix T. The components of the transform matrix T (e.g., $S_1$ and $S_0$ in this example) include the system characteristics (e.g., the matrices and/or other characteristics) of the manufacturing system and the reference system. As described herein, the characteristics and/or the matrices comprise calibration data for the individual systems and/or other information. A matrix may comprise a 4 x 4 matrix for individual points on a pupil. The calibration data may be obtained electronically from a system itself (e.g., for the manufacturing system), programmed by a user (e.g., for the reference system), and/or determined in other ways. As shown in Figure 8, a given intensity metric $I_1$ may be multiplied by the transformation matrix T to determine a mapped intensity metric $\widehat{I}_1$.

Determining the mapped intensity metric may comprise a linear transform of measured channel intensities. Determining the mapped intensity metric may comprise combining pointwise linear transforms of measured channel intensities. Individual measurement channels may be characterized by an incoming-outgoing polarization, a grating to sensor rotation, a wavelength, and/or other parameters. Polarized light comprises a light wave that is vibrating in a single plane. Light may be polarized with a filter and/or with other components. Polarized light comprises a light wave of which the electric field vector oscillates in a single direction (linear polarization) or in a rotating fashion (circular or elliptical polarization). In the case of linearly polarized light, a direction attribute, e.g. H, V, S or P, is used to specify the direction. In the case of circular or elliptical polarized light, a rotational sense and/or ellipticity attribute is used to specify the light. In some embodiments, a grating to sensor rotation may comprise an azimuthal angle between a substrate and a sensor in a manufacturing system used to measure reflectivity, intensity, and/or other parameters. The wavelength may refer to the wavelength of light used by the manufacturing system for measuring the reflectivity, intensity, and/or other parameters.

The incoming-outgoing linear polarization comprises horizontal (in) horizontal (out) (H-H), vertical horizontal (V-H), horizontal vertical (H-V), and/or vertical vertical (V-V). The polarization attribute H or V refers to the linear polarization direction of the light as it (e.g., virtually) travels through the pupil plane of the objective. The H-direction refers to a first chosen direction in the pupil plane. The V direction refers to a second direction perpendicular to the first direction. Said filters to select incoming and outgoing H and V polarizations may be aligned accordingly. The incoming-outgoing linear polarization may comprise S-P, where S ("Senkrecht") and P (Parallel) form machine independent polarization directions. The S and P polarization directions are defined in relation to the plane spanned by the incoming and outgoing light directions on/from the target. The S direction refers to a first direction perpendicular to said plane. The P direction associated with the incoming light is perpendicular to said S direction and perpendicular to the propagation direction of the incoming light. The P direction associated with the outgoing light is perpendicular to said S direction and perpendicular to the propagation direction of the outgoing light. In some embodiments, the grating to sensor rotation comprises a set of given angles (these can be any angles whatsoever), and the set of given angles plus 180 degrees.

Determining the mapped intensity metric may comprise mapping individual intensities directly from different points on a pupil, and mapping corresponding intensities from reciprocal points on the pupil. For example, Figure 9 illustrates mapping individual intensities directly from different points 80 on a pupil, and mapping corresponding intensities from reciprocal points 82 on the pupil. Figure 9 shows two sets of points 80 and 82 for four pupils 83, 84, 85, 86, 87, 88, 89, 90 (each pupil in each set labeled individually) at grating-to-sensor rotations (GTS) of 0 (e.g., set of points 80) and 180 degrees (e.g., set of points 82), for a certain wavelength of light. In this example, the mapped pupil (intensity) 81 (e.g., the mapped intensity metric) is HV (H-in, V-out). In this example, it is assumed that diffraction orders are absent. As shown in Figure 9, in total, 16 points may contribute in determining the indicated mapped pupil point: the 8 "direct" points 91, being at the same position in the pupil as the mapped point, and the 8 "reciprocal" points 92 being at the opposite position in the pupil. The reciprocal points 92 can be included in the mapping because of reciprocity relations that hold if the direction is reversed. These relations hold in the reflectivity domain.

Determining the mapped intensity metric may comprise weighting the intensities directly mapped from the different points on the pupil, and the corresponding intensities from the reciprocal points on the pupil. The weighting is based on the calibration data in the manufacturing system matrix and/or the reference system matrix, a corresponding vectorized form of the reflectivity (as described below), and/or other information. Individual weights are determined based on an incoming polarization, an outgoing polarization, a grating to sensor rotation, a reciprocity, a diffraction order, and/or other parameters associated with a given intensity metric.

For example, the individual mapped points indicated by arrows shown in Figure 9 may contribute different weights to the mapped intensity metric 81. The weights may depend on the calibration data in the manufacturing and/or reference system matrix S. Individual weights may be adjusted by a user and/or have other characteristics. Continuing with this example, the same connections, but with different weights, may be made if a different pupil point is chosen for mapping, e.g. HH. It should be noted that all measured pupils (e.g., co-pol and cross-pol) may be involved in a given mapping. As illustrated in Figure 9, two types of points are involved: direct points 91 and reciprocal points 92. Also, more than one grating-to-sensor rotation may be involved.

The relationship between reflectivity R and intensity I (e.g., an intensity metric) may be expressed as:

$$I = tr\left(M_{out} R \rho_{in} R^\dagger\right) \qquad (1)$$

$$I = r^\dagger S r, \quad S = \rho_{in}^T \otimes M_{out} \quad (2)$$

Relation (1) is directly expressed in terms of 2x2 Hermitian density matrices $\rho_{in}$ and $M_{out}$, which include the calibration data for the manufacturing system that generated the intensity (e.g., intensity metric). In the expression for I, the manufacturing system state is entangled with the reflectivity R. The system state is characterized/made-up by $\rho_{in}$ and $M_{out}$. By "entangled", it is meant that in this equation they appear as two separate entities as a product with "R" in between. A single matrix S that combines both $\rho_{in}$ and $M_{out}$ in a single entity enables making linear combinations, for example. In these expressions, "†" stands for "conjugate transpose", or "Hermitian transpose". "T" stands for "transpose". Relation (1) can be written into the form shown in relation (2), using the (manufacturing) system matrix S, being the Kronecker product of $\rho_{in}$ and $M_{out}$. Now S has become a 4x4 Hermitian matrix, and r is the vectorized form of the reflectivity R. Note that $\rho_{in}$ and $M_{out}$, and hence S depend on incoming polarization, outgoing polarization, grating-to-sensor rotation, diffraction order, etc. If

$$r = \begin{pmatrix} r1 \\ r2 \\ r3 \\ r4 \end{pmatrix}$$ then $r^\dagger = (r1, r2, r3, r4)^*$, with * denoting the complex conjugate.

As a reminder, in relation (2), intensity I (e.g., an intensity metric) is determined by a manufacturing system (e.g., as described above), S is a system matrix (e.g., comprising one or more manufacturing characteristics as appropriate), and the reflectivity r is unknown (and need not be known). An advantage of using the system matrix S is that the (manufacturing) system properties only enter into the mathematics once, and in a linear way. This enables making linear combinations of sets of equations, even if the actual reflectivity R or r is unknown.

In relation (2), the system matrix S is "anonymous". In reality it is associated with an incoming polarization, an outgoing polarization, a grating-to-sensor rotation, reciprocity, a diffraction order, and/or other calibration information. Similarly, the intensity I may be associated with incoming polarization, outgoing polarization, grating-to-sensor rotation, and/or other calibration information. A "mapped intensity (metric) may describe the intensity (metric) that would have been expected to be determined on the reference system.

In an example, only the incoming and outgoing polarizations are used and it is assumed that four pupils are measured: HH, HV, VH, and VV. Reciprocity is not taken into account in this example. The four mapped pupils with the same polarization labels may be determined. There are four expressions corresponding to the four polarization states of I. Taking linear combinations of these equations comprises taking linear combinations of the manufacturing system matrix S (or matrices) on one side (without the need to know r), and the same linear combinations of I on the other side. For each mapped polarization label the linear combinations are sought such that the resulting combination of the actual system matrices S approaches the corresponding reference system matrix with that same mapped polarization label (HH in the example). The linear combination can be optimized for instance with respect to a minimal Frobenius norm of the difference between the combination of manufacturing system matrices and the corresponding reference system matrix. Also other choices can be made. Finally, the linear combination is applied to the intensities I to yield the mapped (or "reference") intensity. Carrying out the procedure for other mapped polarization labels gives the mapping matrix T that transforms measured intensities to mapped intensities. The mapping operation (e.g., operation 64 shown in Figure 6 - determining the mapped intensity metric) may be a pointwise operation involving points at the same pupil-position and in the more generic case also from the opposite (reciprocal) position.

A "default" use case for such a system(s) and method(s) may be to map to a reference system that somehow resembles the actual manufacturing systems used. Typically, an idealized version of such a system is taken for reference. However, the principles described herein can also be used to define a (hypothetical and/or virtual) reference system that may be difficult to make in reality. In doing so it may be possible to extract intrinsic (semiconductor manufacturing) stack properties that virtually do not depend on any physical manufacturing system. The intrinsic optical stack properties are usually expressed in terms of a complex reflectivity matrix. The elements of this matrix act on the S and P polarization components of the light, where S ("Senkrecht") and P (Parallel) form machine independent polarization directions, only depending on the direction of the incoming/outgoing light.

As such, the physical response of each metrology tool is captured in the system matrix S (see Equation (2) above). The system matrix S matrix is a complex Hermitian matrix characterized by 16 independent real numbers corresponding to 16 "degrees of freedom". To build a reference system matrix with 16 degrees of freedom from actual system matrices, requires 16 independent "observables". Each observable corresponds to a measurement (measured pupil) in a certain physical configuration; e.g., as characterized by incoming polarization (e.g. H or V), outgoing polarization (e.g. H or V), retarders in the incoming or outgoing path (intended or as a side effect of the optics used), attenuations (e.g., due to optics transmissions or contaminants), or any other optical effect that can be captured in the Jones framework.

In many present metrology systems, such as have been described herein, the optical system only allows combinations of different incoming and outgoing polarizations and target rotations. As a consequence, these systems only allow to measure a maximum of 8 observables assuming 3 wafer orientations. With two orientations, only 7 observables can be measured. For example, for a single wafer rotation, different polarization states provide 4 degrees of freedom: HH, HV, VH, and VV. The amount of additional degrees of freedom which can be added via wafer rotation is limited. Different wafer rotations effectively rotate the axes of H and V, which does not always provide linearly independent solutions. For example, adding wafer rotations that are integer multiples of 90 degrees will not increase the number of degrees of freedom. As mapping takes linear combinations, with double angle formulas it is possible to create certain other angles: with 3 independent wafer rotations any other wafer rotation can be made and from that point onwards, adding wafer rotations will not increase degrees of freedom. As such, there is no way mathematically to go beyond this lower dimensional subspace with more wafer rotations.

With only 8 of the required 16 observables available, an exact mapping to the reference machine is very difficult. This limits the matching performance in many applications of observable matching techniques.

Furthermore, observable mapping using present methods cannot effectively compensate for objective lens phase retardation variation, which has a significant impact on tool-to-tool parameter of interest (e.g., overlay) matching. Simulations show that objective lens phase retardation variation (hereafter referred to as "alpha variation") has a significant impact on tool-to-tool overlay matching. However, neither diffraction efficiency nor observable mapping normalization methods can compensate for a varied phase retardation. In the context of diffraction efficiencies mapping, the reason that phase retardation cannot be compensated for is that the perfect mirror used for normalization responds differently to alpha variations than the measured target. In the context of observable mapping, multiple wafer orientations or wafer rotations do not possess the necessary degrees of freedom to compensate for alpha variations.

The fact that it is not presently possible to compensate for phase retardation variations, even with perfect calibration knowledge of the retardation values, is a significant issue in overlay matching.

It is therefore proposed to extend the degrees of freedom sampled by each metrology tool beyond the 8 presently available (i.e., to at least 9), and up to the maximal (16) number of degrees of freedom in the Jones model. It is proposed that this be implemented by providing one or more additional optical elements within the illumination and/or detection optics of each tool.

In particular, the proposal may comprise providing such additional polarization-changing optical elements within the illumination and/or detection optics of each tool, wherein at least one of the additional optical elements is provided within an illumination mode selector (IMS) and/or detection mode selector (DMS), such as, for example in each case, a rotatable aperture wheel. The aperture wheel includes a plurality of apertures arranged in different sectors of the aperture wheel. Each sector corresponds to a different illumination mode or detection mode as appropriate. Thus, different illumination modes/detection models may be selected by rotating the respective aperture wheel. Each illumination mode or detection mode corresponds to a different position of the aperture wheel. The IMS/DMS may each be mounted on a central rotatable shaft, or axle, and may be powered by a motor to rotate the IMS/DMS into different positions, and hence, different illumination/detection modes. Alternative mechanical arrangements for an IMS/DMS may comprise, for example, a motor-driven linear slider comprising an array (e.g., a 1D array, or possibly a 2D array) of apertures. In either case, each aperture of the IMS/DMS may be individually moved or switched into the illumination path/detection path. The IMS aperture wheel may be provided in a pupil plane (or conjugate thereof) of an illumination branch (within the illumination optics) of the metrology tool, e.g., at the plane labeled 13 in Figure 5(a). Similarly the DMS aperture wheel may be provided in a pupil plane (or conjugate thereof) of a detection branch (within the detection optics) of the metrology tool.

In an embodiment, at least one of the additional polarization-changing optical elements may comprise a waveplate or retarder. For example, the waveplate may comprise a quarter waveplate (QWP) or more generally a waveplate operable to impose a retardation (phase shift between the polarization components) of between $0.1\lambda$ and $0.4\lambda$, or between $0.2\lambda$ and $0.3\lambda$, the waveplate having its fast and slow axes oriented obliquely (e.g., at an angle which is not an integer multiple of 90) with respect to the horizontal polarization axis of the illumination polarizing beam splitter (PBS). In a single illumination QWP embodiment, the oblique angle may be between 30 and 60 degrees, between 40 and 50 degrees, between 42 and 48 degrees, between 44 and 46 degrees or at 45 degrees. Such a QWP can be used to impose circular polarization (or elliptical polarization, depending on orientation) on the linearly polarized input illumination from the PBS, with different handedness for the H and V incoming polarizations. Such a single QWP may increase the number of degrees of freedom or observables by 5 (from 8 to 13, again assuming 3 wafer orientations).

Calculations with a variable retarder suggest that a 90 degree phase delay (i.e., a QWP or approximation thereof) combined with an approximately 45 degree orientation (e.g., 45+/- 1 degrees, 45+/- 5 degrees, 45 +/- 10 degrees, 45+/- 15 degrees) of the retarder with respect to the linear polarization of the incoming light is maximally orthogonal to current measurements.

13 observables is a considerable improvement on the 8 observables presently available on many tools presently, and can compensate for alpha map variations via observable mapping. As such, provision of a single or first QWP by itself is within the scope of this disclosure. However, the concepts can be further extended by incorporating a second additional optical element within the IMS. In an embodiment, the second optical element may comprise either a half-waveplate (HWP) or more generally a waveplate operable to impose a retardation of between $0.4\lambda$ and $0.6\lambda$, or between $0.45\lambda$ and $0.55\lambda$, the waveplate having the fast or slow axis oriented at between 20 and 25 degrees or between 22 and 23 degrees, e.g., at 22.5, with respect to the horizontal polarization axis of the illumination PBS, or a linear polarizer with its polarization axis oriented at between 40 and 50 degrees or between 44 and 46 degrees, e.g., at 45 degrees, with respect to the horizontal polarization axis of the illumination PBS. In either case, a 45 degree linear polarization state is imposed on the measurement illumination. This provides an addition 2 degrees of freedom or observables (i.e., providing both the QWP and HWP/45 degree linear polarizer increases the number of observables to 15).

The QWP and HWP/linear polarizer embodiment just described may be further extended to obtain the full 16 degrees of freedom by further providing a detection polarization-changing optical element which may be switched into the detection branch, e.g., before the detection PBS. The detection arrangement may be such that it is possible to switch between fully open detection and detection via the polarization-changing optical element. In an embodiment, the detection polarization-changing optical element may comprise a detection QWP (or more generally a detection waveplate operable to impose a retardation of between $0.1\lambda$ and $0.4\lambda$, or between $0.2\lambda$ and $0.3\lambda$) oriented obliquely, e.g., between 44 and 46 degrees (e.g., 45 degrees) with respect to the horizontal polarization axis of the detection PBS. Alternatively, this QWP may be a rotatable QWP.

In an embodiment, the metrology tool may comprise an illumination aperture wheel and/or a detection aperture wheel; each comprising at least an open aperture, a QWP (e.g., oriented at 45 degrees or as described herein) and a HWP (e.g., oriented at 22.5 degrees or as described herein) or 45 degree linear polarizer. These aperture wheels may be located respectively after the illumination PBS and before the detection PBS. This arrangement (with illumination and detection aperture wheels) covers the full 16 degrees of freedom without needing reciprocity of the measured target. Reciprocity is a physical property of the interaction of the light with the target which can be used to create more degrees of freedom for observable mapping. This does place additional requirements on calibration accuracy, however.

In a different embodiment, the IMS may comprise first and second QWPs (or waveplates approximating QWPs as described) with fast or slow axes oriented at respective different angles $\alpha$ and $\beta$ with respect to the horizontal polarization axis of the illumination PBS; where $\alpha \neq \beta$ and $\alpha$, $\beta$ both not integer multiples of 90. For example, $\alpha$ may be 30 degrees and $\beta$ may be 60 degrees. This arrangement provides us up to 15 degrees of freedom. As such, an additional degree of freedom may be obtained by combining this arrangement with a detection polarization-changing optical element as has been described. In an embodiment, an illumination aperture wheel and a detection aperture wheel, respectively located after the illumination PBS and before the detection PBS, may be provided, each comprising containing an open aperture and the two QWP as described (with fast/slow axis oriented at $\alpha$ and $\beta$ respectively). This arrangement covers the full 16 degrees of freedom without needing reciprocity of the measured target.

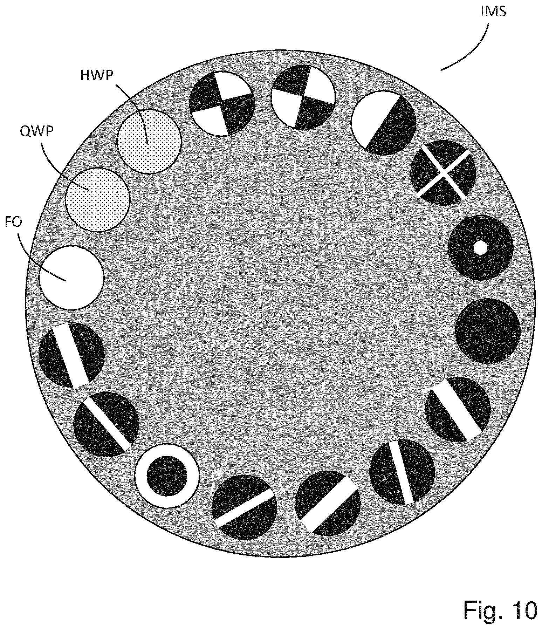

Figure 10 is a schematic diagram of an IMS, and specifically an aperture wheel, according to an embodiment. The IMS comprises various apertures, each of which can be switched into the illumination beam to configure the illumination profile as is well known. In addition to these apertures, there is at least one, and in this example two, polarization-changing optical elements: a quarter waveplate QWP (e.g., with fast/slow axis oriented at 45 degrees with respect to the horizontal polarization axis of the illumination PBS) and half waveplate HWP (e.g., with fast/slow axis oriented at 22.5 degrees with respect to the horizontal polarization axis of the illumination PBS). As has been described, a second QWP oriented at a different angle to the first QWP or a linear polarizer oriented at 45 degrees with respect to the horizontal polarization axis of the illumination PBS may replace the HWP.

All QWPs in this embodiment, and throughout the description as a whole, may comprise waveplates imposing retardations between $0.1\lambda$ and $0.4\lambda$ or $0.2\lambda$ and $0.3\lambda$, all HWPs in this embodiment, and throughout the description as a whole, may comprise waveplates imposing retardations between $0.4\lambda$ and $0.6\lambda$ or $0.45\lambda$ and $0.55\lambda$ and all specific angles described in this embodiment, and throughout the description as a whole, may be in a range +/-1 degree, +/5 degrees, +/- 10 degrees or any of the ranges provided elsewhere in this description.

In an embodiment, as shown here, the QWP and HWP may be placed close together and/or close to the full open aperture FO. As such, the QWP, HWP and full open aperture FO may be located in adjacent or successive aperture positions on the IMS. This provides the smallest switching times during measurement.

It can be appreciated that the specific arrangements described herein are examples and other combinations of optics are also possible.

The techniques disclosed herein may be used for any pupil-based metrology, e.g., using the first measurement branch and detector 19 of the tool depicted in Figure 5(a). Such metrology methods include *inter alia* after-etch inspection (AEI) such as IDM or pupil-based after-develop inspection ADI such as (bright-field) diffraction based DBO overlay and diffraction based focus DBF measurement. For pupil-based ADI this could be done by applying higher-order observable-mapping to the DBO/DBF measured pupil using the additional QWP/HWP signals as described to improve matching.

Further embodiments are disclosed in the subsequent list of numbered clauses:

1. An illumination mode selector for use in an illumination branch of an optical metrology tool, the illumination mode selector comprising:

   a plurality of illumination apertures; and
   at least one polarization-changing optical element;
   wherein each of the illumination apertures and each of the at least one polarization-changing optical element are individually switchable into an illumination path of the optical metrology tool.

2. An illumination mode selector as defined in clause 1, wherein the at least one polarization-changing optical element comprises at least one waveplate.

3. An illumination mode selector as defined in clause 2, wherein the at least one waveplate comprises at least waveplate operable to impose a retardation on one polarization component of between $0.1\lambda$ and $0.4\lambda$.

4. An illumination mode selector as defined in clause 2 or 3, wherein the at least one waveplate comprises at least one quarter waveplate.

5. An illumination mode selector as defined in clause 3 or 4, wherein said at least one waveplate comprises a fast or slow axis oriented at an oblique angle which is not an integer multiple of 90 degrees, with respect to a horizontal polarization axis of an illumination polarizing beam splitter of the optical metrology tool.

6. An illumination mode selector as defined in clause 5, wherein said oblique angle is between 40 and 50 degrees.

7. An illumination mode selector as defined in clause 5, wherein said oblique angle is substantially 45 degrees.

8. An illumination mode selector as defined in clause 3, wherein the at least one waveplate comprises a first waveplate operable to impose a retardation on one polarization component of between $0.1\lambda$ and $0.4\lambda$, comprising a fast or slow axis oriented at a first angle and a second waveplate operable to impose a retardation on one polarization component of between $0.1\lambda$ and $0.4\lambda$, comprising a fast or slow axis oriented at a second angle, said first angle and second angle each comprising a respective oblique angle with respect to a horizontal polarization axis of an illumination polarizing beam splitter of the optical metrology tool which is not an integer multiple of 90 degrees, said first angle and second angle being different.

9. An illumination mode selector as defined in clause 8, wherein said first waveplate and said second waveplate each comprise a quarter waveplate.

10. An illumination mode selector as defined in clause 8 or 9, wherein said first angle is between 25 and 35 degrees and said second angle is between 55 and 65 degrees.

11. An illumination mode selector as defined in any of clauses 3 to 7, wherein the at least one waveplate further comprises a waveplate operable to impose a retardation on one polarization component of between $0.4\lambda$ and $0.6\lambda$.

12. An illumination mode selector as defined in any of clauses 3 to 7, wherein the at least one waveplate further comprises a half waveplate.

13. An illumination mode selector as defined in clause 11 or 12, wherein said waveplate operable to impose a retardation on one polarization component of between $0.4\lambda$ and $0.6\lambda$ or said half waveplate comprises a fast or slow axis oriented at an angle between 20 and 25 degrees with respect to a horizontal polarization axis of an illumination polarizing beam splitter of the optical metrology tool.

14. An illumination mode selector as defined in clause 13, wherein said waveplate operable to impose a retardation on one polarization component of between $0.4\lambda$ and $0.6\lambda$ or said half waveplate is oriented at substantially 22.5 degrees with respect to said horizontal polarization axis.

15. An illumination mode selector as defined in any of clauses 3 to 7, further comprising a linear polarizer oriented at an oblique angle which is not an integer multiple of 90 degrees, with respect to a horizontal polarization axis of an illumination polarizing beam splitter of the optical metrology tool.

16. An illumination mode selector as defined in clause 15, wherein said oblique angle is between 40 and 50 degrees.

17. An illumination mode selector as defined in clause 15, wherein said oblique angle is substantially 45 degrees.

18. An illumination mode selector as defined in any preceding clause, wherein said plurality of illumination apertures comprise a fully open aperture.

19. An illumination mode selector as defined in clause 18, wherein each said at least one polarization-changing optical element and said fully open aperture are comprised in successive or adjacent locations on said illumination mode selector.

20. An illumination mode selector as defined in any preceding clause, wherein said illumination mode selector comprises an aperture wheel, wherein said plurality of illumination apertures and said at least one polarization-changing optical element are each located in a respective sector of the aperture wheel.

21. An optical metrology tool comprising:

> an illumination branch for directing illumination onto a sample, said illumination branch comprising an illumination polarizing beam splitter having a horizontal polarization axis;
> a detection branch for detecting said illumination having been reflected and/or scattered by said sample; and one or both of: an illumination mode selector in the illumination branch and a detection mode selector in the detection mode branch;
> wherein said illumination mode selector comprises:
>
>> a plurality of illumination apertures; and
>> at least one polarization-changing optical element;
>> wherein each of the illumination apertures and each of the at least one polarization-changing optical element are individually switchable into an illumination path of the optical metrology tool; and
>> wherein said detection mode selector comprises:
>>
>>> at least one detection aperture; and
>>> at least one detection polarization-changing optical element;
>>> wherein each at least one detection aperture and each of the at least one polarization-changing optical element are individually switchable into said detection branch, said detection branch comprising a detection polarizing beam splitter having a horizontal polarization axis.

22. An optical metrology tool as defined in clause 21, comprising said illumination mode selector in the illumination branch, wherein the at least one polarization-changing optical element comprises at least one waveplate.

23. An optical metrology tool as defined in clause 22, wherein the at least one waveplate comprises at least one waveplate operable to impose a retardation on one polarization component of between $0.1\lambda$ and $0.4\lambda$.

24. An optical metrology tool as defined in clause 22 or 23, wherein the at least one waveplate comprises at least one quarter waveplate.

25. An optical metrology tool as defined in clause 23 or 24, wherein said at least one waveplate comprises a fast or slow axis oriented at an oblique angle which is not an integer multiple of 90 degrees, with respect to said horizontal polarization axis of the illumination polarizing beam splitter.

26. An optical metrology tool as defined in clause 25, wherein said oblique angle is between 40 and 50 degrees.

27. An optical metrology tool as defined in clause 25, wherein said oblique angle is substantially 45 degrees.

28. An optical metrology tool as defined in clause 23, wherein the at least one waveplate comprises a first waveplate operable to impose a retardation on one polarization component of between $0.1\lambda$ and $0.4\lambda$, comprising a fast or slow axis oriented at a first angle and second waveplate operable to impose a retardation on one polarization component of between $0.1\lambda$ and $0.4\lambda$, comprising a fast or slow axis oriented at a second angle, said first angle and second angle each comprising a respective oblique angle with respect to said horizontal polarization axis of the illumination polarizing beam splitter which is not an integer multiple of 90 degrees, said first angle and second angle being different.

29. An optical metrology tool as defined in clause 28, wherein said first waveplate and said second waveplate each comprise a quarter waveplate.

30. An optical metrology tool as defined in clause 28 or 29, wherein said first angle is between 25 and 35 degrees and said second angle is between 55 and 65 degrees.

31. An optical metrology tool as defined in clause 29 or 30, further comprising said detection mode selector, said detection mode selector further comprising a fully open aperture and a first detection waveplate operable to impose a retardation on one polarization component of between $0.1\lambda$ and $0.4\lambda$ comprising a fast or slow axis oriented at said first angle and a second detection quarter waveplate comprising a fast or slow axis oriented at a second detection angle.

32. An optical metrology tool as defined in clause 31, wherein said first detection comprises a quarter waveplate.

33. An optical metrology tool as defined in any of clauses 23 to 27, wherein the at least one waveplate further comprises a waveplate operable to impose a retardation on one polarization component of between $0.4\lambda$ and $0.6\lambda$.

34. An optical metrology tool as defined in any of clauses 23 to 27, wherein the at least one waveplate further comprises a half waveplate.

35. An optical metrology tool as defined in clause 33 or 34, wherein said waveplate operable to impose a retardation on one polarization component of between $0.4\lambda$ and $0.6\lambda$ or said half waveplate comprises a fast or slow axis oriented at an angle between 20 and 25 degrees with respect to said horizontal polarization axis of the illumination polarizing beam splitter.

36. An optical metrology tool as defined in clause 33 or 34, wherein said waveplate operable to impose a retardation on one polarization component of between $0.4\lambda$ and $0.6\lambda$ or said half waveplate is oriented at substantially 22.5 degrees with respect to said horizontal polarization axis.

37. An optical metrology tool as defined in any of clauses 23 to 27, further comprising a linear polarizer oriented at an oblique angle which is not an integer multiple of 90 degrees, with respect to a horizontal polarization axis of an illumination polarizing beam splitter of the optical metrology tool.

38. An optical metrology tool as defined in clause 37, wherein said oblique angle is between 40 and 50 degrees.

39. An optical metrology tool as defined in clause 38, wherein said oblique angle is substantially 45 degrees.

40. An optical metrology tool as defined in any of clauses 22 to 39, wherein said plurality of illumination apertures comprise a fully open aperture.

41. An optical metrology tool as defined in clause 40, wherein each said at least one polarization-changing optical element and said fully open aperture are comprised in successive or adjacent locations on said illumination mode selector.

42. An optical metrology tool as defined in any of clauses 22 to 41, wherein said illumination mode selector comprises an aperture wheel, wherein said plurality of illumination apertures and said at least one polarization-changing optical element are each located in a respective sector of the aperture wheel.

43. An optical metrology tool as defined in any of clauses 22 to 42, wherein said illumination mode selector is located in a pupil plane or conjugate thereof within the illumination branch.

44. An optical metrology tool as defined in clause 43, comprising said detection mode selector, wherein the detection polarization-changing optical element comprises a detection wave plate operable to impose a retardation on one polarization component of between $0.1\lambda$ and $0.4\lambda$.

45. An optical metrology tool as defined in clause 44, wherein the detection wave plate comprises a detection quarter wave plate.

46. An optical metrology tool as defined in clause 44 or 45, wherein said detection quarter waveplate comprises a fast or slow axis oriented at an oblique angle which is not an integer multiple of 90 degrees, with respect to said horizontal polarization axis of the detection polarizing beam splitter.

47. An optical metrology tool as defined in clause 46, wherein said oblique angle is between 40 and 50 degrees.

48. An optical metrology tool as defined in clause 47, wherein said oblique angle is substantially 45 degrees

49. An optical metrology tool as defined in clause 44 or 45, wherein said detection waveplate comprises a rotatable detection waveplate.

50. An optical metrology tool as defined in any of clauses 44 to 49, wherein said detection mode selector comprises a fully open aperture.

51. An optical metrology tool as defined in any of clauses 44 to 50, wherein said detection mode selector comprises an aperture wheel.

52. A method of determining a mapped intensity metric, the method comprising:

configuring the optical metrology tool of any of clauses in a plurality of different measurement configurations, said plurality of different measurement configurations comprising one or more measurement configurations obtained by a respective switching of each of the at least one polarization-changing optical elements into the illumination path of the optical metrology tool of any of clauses 21 to 51;

building a virtual system matrix from a plurality of observables, each observable corresponding to a respective measurement configuration of said plurality of measurement configurations, said plurality of observables numbering at least 9.

53. A method as defined in clause 52, wherein said plurality of observables number at least 13.

54. A method as defined in clause 52, wherein said plurality of observables number at least 15.

55. A method as defined in clause 52, wherein said plurality of observables number 16.

56. A method as defined in any of clauses 52 to 55, wherein said method comprises:

retrieving a manufacturing system matrix comprising first calibration data for an optical metrology tool;

determine an intensity metric for the optical metrology tool based on the manufacturing system matrix;

determine weights, based on the manufacturing system matrix and the virtual system matrix, for mapping intensity metrics of the manufacturing system to respective intensity metrics of the virtual system; and

determine a mapped intensity metric for the virtual system based on the weights and the intensity metric to mimic the determination of the intensity metric on the optical metrology tool using the virtual system.

57. A method as defined in clause 56, wherein determining the mapped intensity metric comprises combining pointwise linear transforms of measured channel intensities, with individual measurement channels characterized by an incoming-outgoing polarization, a grating to sensor rotation, and a wavelength.

58. A method as defined in clause 57, wherein determining the mapped intensity metric comprises mapping individual intensities directly from different points on a pupil, and mapping corresponding intensities from reciprocal points on the pupil.

The concepts disclosed herein may simulate or mathematically model any generic imaging system for imaging sub wavelength features, and may be especially useful with emerging imaging technologies capable of producing increasingly shorter wavelengths. Emerging technologies already in use include EUV (extreme ultra violet), DUV lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range.

While the concepts disclosed herein may be used for imaging on a substrate such as a silicon wafer, it shall be understood that the disclosed concepts may be used with any type of lithographic imaging systems, e.g., those used for imaging on substrates other than silicon wafers, and/or metrology systems. In addition, the combination and sub-combinations of disclosed elements may comprise separate embodiments. For example, predicting a complex electric field image and determining a metrology metric such as overlay may be performed by the same parameterized model and/or different parameterized models. These features may comprise separate embodiments, and/or these features may be used together in the same embodiment.

Although specific reference may be made in this text to embodiments of the invention in the context of a metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An illumination mode selector for use in an illumination branch of an optical metrology tool, the illumination mode selector comprising:

   a plurality of illumination apertures; and
   at least one polarization-changing optical element;
   wherein each of the illumination apertures and each of the at least one polarization-changing optical element are individually switchable into an illumination path of the optical metrology tool.

2. An illumination mode selector as claimed in claim 1, wherein the at least one polarization-changing optical element comprises at least one waveplate.

3. An illumination mode selector as claimed in claim 2 , wherein the at least one waveplate comprises at least one quarter waveplate.

4. An illumination mode selector as claimed in claim 3, wherein said at least one waveplate comprises a fast or slow axis oriented at an oblique angle which is not an integer multiple of 90 degrees, with respect to a horizontal polarization axis of an illumination polarizing beam splitter of the optical metrology tool.

5. An illumination mode selector as claimed in any of claims 3 or 4, wherein the at least one waveplate further comprises a half waveplate.

6. An illumination mode selector as claimed in any of claims 3 or 4, further comprising a linear polarizer oriented at an oblique angle which is not an integer multiple of 90 degrees, with respect to a horizontal polarization axis of an illumination polarizing beam splitter of the optical metrology tool.

7. An illumination mode selector as claimed in any preceding claim, wherein said plurality of illumination apertures comprise a fully open aperture.

8. An illumination mode selector as claimed in claim 7, wherein each said at least one polarization-changing optical element and said fully open aperture are comprised in successive or adjacent locations on said illumination mode selector.

9. An illumination mode selector as claimed in any preceding claim, wherein said illumination mode selector comprises an aperture wheel, wherein said plurality of illumination apertures and said at least one polarization-changing optical element are each located in a respective sector of the aperture wheel.

10. An optical metrology tool comprising:

an illumination branch for directing illumination onto a sample, said illumination branch comprising an illumination polarizing beam splitter having a horizontal polarization axis;
a detection branch for detecting said illumination having been reflected and/or scattered by said sample; and one or both of: an illumination mode selector in the illumination branch and a detection mode selector in the detection mode branch;
wherein said illumination mode selector comprises:

a plurality of illumination apertures; and
at least one polarization-changing optical element;
wherein each of the illumination apertures and each of the at least one polarization-changing optical element are individually switchable into an illumination path of the optical metrology tool; and
wherein said detection mode selector comprises:

at least one detection aperture; and
at least one detection polarization-changing optical element;
wherein each at least one detection aperture and each of the at least one polarization-changing optical element are individually switchable into said detection branch, said detection branch comprising a detection polarizing beam splitter having a horizontal polarization axis.

11. A method of determining a mapped intensity metric, the method comprising:

configuring the optical metrology tool of any of claims in a plurality of different measurement configurations, said plurality of different measurement configurations comprising one or more measurement configurations obtained by a respective switching of each of the at least one polarization-changing optical elements into the illumination path of the optical metrology tool of claim 10;
building a virtual system matrix from a plurality of observables, each observable corresponding to a respective measurement configuration of said plurality of measurement configurations, said plurality of observables numbering at least 9.

12. A method as claimed in claim 11, wherein said plurality of observables number at least 13.

13. A method as claimed in claim 11 or 12, wherein said method comprises:

retrieving a manufacturing system matrix comprising first calibration data for an optical metrology tool;
determine an intensity metric for the optical metrology tool based on the manufacturing system matrix;
determine weights, based on the manufacturing system matrix and the virtual system matrix, for mapping intensity metrics of the manufacturing system to respective intensity metrics of the virtual system; and
determine a mapped intensity metric for the virtual system based on the weights and the intensity metric to mimic the determination of the intensity metric on the optical metrology tool using the virtual system.

14. A method as claimed in claim 13, wherein determining the mapped intensity metric comprises combining pointwise linear transforms of measured channel intensities, with individual measurement channels **characterized by** an incoming-outgoing polarization, a grating to sensor rotation, and a wavelength.

15. A method as claimed in claim 14, wherein determining the mapped intensity metric comprises mapping individual intensities directly from different points on a pupil, and mapping corresponding intensities from reciprocal points on the pupil.

Fig. 1

Fig. 2

Fig. 3

Fig. 4

Fig. 5

Fig. 6

70       72       74

75

76

77

Fig. 7      78      79

$$I_1 \times T = \hat{I}_1$$

Fig. 8

85   86      81      90   89

91

92

83    84      87    88

80        82

Fig. 9

Fig. 10

Europäisches
Patentamt

European
Patent Office

Office européen
des brevets

# EUROPEAN SEARCH REPORT

Application Number

EP 22 17 2390

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ANONYMOUS: "MEMS BASED LIGHT CONTROL", RESEARCH DISCLOSURE, KENNETH MASON PUBLICATIONS, HAMPSHIRE, UK, GB , vol. 694, no. 48 1 January 2022 (2022-01-01), XP007149975, ISSN: 0374-4353 Retrieved from the Internet: URL:ftp://ftppddoc/RDData694_EPO.zip Pdf/694048.pdf [retrieved on 2022-01-17] | 1,9 | INV. G03F7/20 G01N21/88 G01N21/95 G01N21/956 G02F1/01 G06T7/00 |
| Y | * the whole document * | 2,3,5,7, 8,10-15 | |
| X | YEUNG JOON SOHN ET AL: "Analysis of Köhler Illumination for 193 nm Scatterfield Microscope", SPIE, PO BOX 10 BELLINGHAM WA 98227-0010 USA, vol. 7272, 1 January 2009 (2009-01-01), XP040495804, * 1. Introduction * | 1-3 | |
| X | EP 3 454 124 A1 (ASML NETHERLANDS BV [NL]) 13 March 2019 (2019-03-13) | 1-4,6,10 | TECHNICAL FIELDS SEARCHED (IPC) G03F G01N G02F G06T |
| Y | * paragraphs [0055] - [0060]; figures 7-9 * * paragraphs [0112] - [0128] * * paragraphs [0205] - [0208] * * paragraphs [0215] - [0230]; figures 21,22,24A * | 10-15 | |
| X | US 2016/025992 A1 (VAN DER ZOUW GERBRAND [NL] ET AL) 28 January 2016 (2016-01-28) | 1 | |
| Y | * paragraphs [0091] - [0093]; figure 5a * * paragraph [0100]; figure 6 * * paragraphs [0130] - [0132]; figure 16 * | 10 | |

-/--

The present search report has been drawn up for all claims

| Place of search | Date of completion of the search | Examiner |
|---|---|---|
| Munich | 3 November 2022 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................
& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 22 17 2390

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2019/355601 A1 (DANEN ROBERT M [US] ET AL) 21 November 2019 (2019-11-21) <br> * paragraphs [0047] - [0059]; figures 5a,5b * <br> * paragraphs [0079] - [0096]; figure 10 * <br> ----- | 10 | |
| Y | EMIL C PISEANI ET AL: "Demonstration of sub-45 nm features using azimuthal polarization", SPIE, PO BOX 10 BELLINGHAM WA 98227-0010 USA, vol. 6520, 1 January 2007 (2007-01-01), XP040238265, <br> * pages 1-2 * <br> * page 5; figures 5,6 * <br> ----- | 2,3,5,7,8 | |
| Y | ANONYMOUS: "Ship-Wheel Design for Illumination Mode Selector (IMS) Wheel", RESEARCH DISCLOSURE, KENNETH MASON PUBLICATIONS, HAMPSHIRE, UK, GB , vol. 685, no. 7 1 May 2021 (2021-05-01), XP007149338, ISSN: 0374-4353 Retrieved from the Internet: URL:ftp://ftppddoc/RDData685_EPO.zip Pdf/685007.pdf <br> * the whole document * <br> ----- | 8 | |
| Y,D | EP 3 961 304 A1 (ASML NETHERLANDS BV [NL]) 2 March 2022 (2022-03-02) <br> * paragraphs [0072] - [0074] * <br> * paragraphs [0089] - [0098]; figure 8 * <br> * paragraph [0111] * <br> ----- | 11-15 | |

TECHNICAL FIELDS SEARCHED (IPC)

-/--

The present search report has been drawn up for all claims

| Place of search | Date of completion of the search | Examiner |
|---|---|---|
| Munich | 3 November 2022 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 22 17 2390

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2011/139027 A1 (HANSEN STEVEN GEORGE [US]) 16 June 2011 (2011-06-16)<br>* paragraphs [0069] - [0071]; figures 6A-6C *<br>* paragraph [0094]; figures 15A-15C *<br>----- | 11 | |

TECHNICAL FIELDS
SEARCHED        (IPC)

The present search report has been drawn up for all claims

| Place of search | Date of completion of the search | Examiner |
|---|---|---|
| Munich | 3 November 2022 | van Toledo, Wiebo |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
...............................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 22 17 2390

This annex lists the patent family members relating to the patent documents cited in the above-mentioned European search report.
The members are as contained in the European Patent Office EDP file on
The European Patent Office is in no way liable for these particulars which are merely given for the purpose of information.

03-11-2022

| Patent document cited in search report | | Publication date | Patent family member(s) | | Publication date |
|---|---|---|---|---|---|
| EP 3454124 | A1 | 13-03-2019 | CN | 111065971 A | 24-04-2020 |
| | | | EP | 3454124 A1 | 13-03-2019 |
| | | | IL | 273041 A | 30-04-2020 |
| | | | JP | 6999797 B2 | 19-01-2022 |
| | | | JP | 2020533622 A | 19-11-2020 |
| | | | KR | 20200033965 A | 30-03-2020 |
| | | | TW | 201921149 A | 01-06-2019 |
| | | | US | 2019072862 A1 | 07-03-2019 |
| | | | US | 2020285157 A1 | 10-09-2020 |
| | | | WO | 2019048342 A1 | 14-03-2019 |
| US 2016025992 | A1 | 28-01-2016 | NL | 2015160 A | 07-07-2016 |
| | | | TW | 201610602 A | 16-03-2016 |
| | | | US | 2016025992 A1 | 28-01-2016 |
| | | | US | 2018088347 A1 | 29-03-2018 |
| | | | WO | 2016015987 A1 | 04-02-2016 |
| US 2019355601 | A1 | 21-11-2019 | TW | 202004257 A | 16-01-2020 |
| | | | US | 10957568 B1 | 23-03-2021 |
| | | | US | 2019355601 A1 | 21-11-2019 |
| | | | WO | 2019221938 A1 | 21-11-2019 |
| EP 3961304 | A1 | 02-03-2022 | EP | 3961304 A1 | 02-03-2022 |
| | | | WO | 2022042972 A1 | 03-03-2022 |
| US 2011139027 | A1 | 16-06-2011 | CN | 102096331 A | 15-06-2011 |
| | | | JP | 5745832 B2 | 08-07-2015 |
| | | | JP | 2011129907 A | 30-06-2011 |
| | | | KR | 20110068918 A | 22-06-2011 |
| | | | TW | 201207893 A | 16-02-2012 |
| | | | US | 2011139027 A1 | 16-06-2011 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- EP 3961304 A